# EUROPEAN PATENT APPLICATION

(11) **EP 4 567 386 A1**
(43) Date of publication of application: **11.06.2025**
(21) Application number: 24306953.1
(22) Date of filing: 25.11.2024
(51) Int. Cl.: G01H 9/00, G01R 31/11, G01V 3/02

(54) **A SYSTEM FOR DETECTING DISTURBANCES IN AN UNDERGROUND AREA ABOVE A POWER CABLE**

(30) Priority: 08.12.2023 NO 20231329
(71) Applicant: Nexans, 92400 Courbevoie (FR)
(72) Inventor: GASPARI, Roberto, 92400 COURBEVOIE (FR)
(74) Representative: Onsagers AS

(57) **Abstract**

A system (1) for detecting disturbances in an underground area above a power cable comprises a signal transmitter (26) and a sensing element (11) configured to be buried in the ground in the underground area. The sensing element (11) is signally connected to the signal transmitter (26) and is configured to interact with a signal from the signal transmitter (26) to create a variation in the signal when the sensing element (11) is exposed to a physical impact. The system (1) also comprises a signal processing unit (25) connected to the signal transmitter (26), where the signal processing unit (25) is signally connected to the sensing element (11), and where the signal processing unit (25) is configured to detect the variation in a signal from the sensing element (11).

## Description

### Field of the invention

The present invention relates to a system for detecting disturbances in an underground area above a power cable or a power cable network.

### Background of the invention

According to recent statistics over 50% of faults in GRID and off-shore installations are caused by an external cause.

The external cause could be direct drilling or excavating on top of the energy cable path or intrusion of anchors and trailers net for submarine links or other physical impacts that disturbs the ground surrounding the cables.

Existing technologies to identify at the onset the approach of e.g. a trailer vessel or digging machinery are extremely costly and not mature enough to avoid false alarms. Such technology relies on Distributed Acoustic Sensing (DAS) and algorithms that are capable of separating normal sound sources from potentially damaging ones. In order to avoid false alarms, for example due to transients that occurs without any real events, it is common for such systems to wait at least 30 minutes after a first signal is detected to check if there really is a event that needs to be followed up. This makes it difficult to have a quick response to external impacts that may cause a fault in a cable or grid.

At the same time, it is common to install warning tapes indicating the presence of power cables to allow an excavator operator to interrupt the digging when the warning tapes are uncovered and identified.

In most instances, nevertheless work is not interrupted in time to avoid partial or total damage to the infrastructure. Furthermore, in order to avoid the responsibility and the liability for the repairs and loss of operation, the dug up trench is often reclosed without informing the owners/operators.

Partial or total damage to the assets is therefore often not promptly recognized, either because at the time of damage the asset was not utilized, or because a partial damage becomes evident, if any, at a later stage, in some occurrences after months and years.

Document EP 2 635 875 B1 discloses an integrity monitoring system and a method of monitoring integrity of a stationary structure.

Document EP 0 902 901 B1 discloses a locatable locating tape for finding in particular non-metallic cables and pipelines buried in the ground.

### Summary of the invention

A system for detecting disturbances in an underground area above a power cable and/or poser cable network, comprises in one configuration:
- a signal transmitter,
- a sensing element configured to be buried in the ground in the underground area and being signally connected to the signal transmitter and configured to interact with a signal from the signal transmitter to create a variation in the signal when the sensing element is exposed to a physical impact,
- a signal processing unit connected to the signal transmitter and signally connected to the sensing element, where the signal processing unit is configured to detect the variation in a signal from the sensing element.

The system may be used for detecting disturbances caused by physical impact in any underground area where cables are buried, both offshore, ie. under the seabed and onshore.

The sensing element and signal processing unit being signally connected to the signal transmitter and the sensing element, respectively, should in this description be understood as them being able to transmit and/or receive signals to/from the component they are signally connected to. The transmittal/receipt of signals may be carried out by means of a wired or wireless connection, such as electrical or optical signal cables, electrical wires, Bluetooth, Wi-Fi, etc.

The system can be a self-sustaining, independent system which can detect a physical impact near the location in the ground where the sensing element is buried and can function as an early warning system for early detection of physical impacts that can cause damages to a power cable or power cable network present in the area.

Variation in signal should in this description be understood as any significant change or deviation in the signal, such as termination/discontinuance of the signal, amplitude variations, frequency variations, etc.

The sensing element is in one configuration an optical fiber, and the signal transmitter is configured to transmit an optical signal. The signal processing unit can be connected to or comprise an optical time domain reflectometer configured to detect a variation in the optical signal.

In another configuration, the sensing element is one or a pair of electrical conductors and the signal transmitter is configured to transmit an electrical signal. The signal processing unit may comprise an ohm meter, for example a high-resistivity ohm meter or other suitable means for detecting and/or monitoring electrical signals.

The signal processing unit can be configured to identify and record the point in time when a variation in the signal occurs.

The sensing element can be comprised in a monitoring device for depositing in the underground.

The monitoring device comprises in one configuration a micro-duct configured to receive the sensing element. The monitoring device may in other configurations be other devices, such as a warning tape commonly used for notifying an excavator operator that a cable is buried in the ground further down.

In one configuration, the system comprises multiple sensing elements, and the signal processing unit is configured to, when a variation in the signal is detected in one of the sensing elements, identify the location of the sensing elements.

The multiple sensing elements can be connected in series to form an extended sensing element. For example, can each of the multiple sensing elements comprise an input terminal and an output terminal configured to connect to an output terminal and input terminal of another sensing element, respectively. When multiple sensing elements are connected in series, a sensing element of any length can be provided by selecting the number of sensing elements of a specific length that matches the wanted length and connecting them in series.

To achieve a specific length, there may sometimes be necessary to cut a sensing element to a shorter length. An input or output terminal can be connected to the cut end of the sensing element, or any other termination suitable for connecting the sensing element to the system may be arranged at the cut end of the sensing element.

The connections between multiple sensing elements can be a waterproof connection, or the connection between multiple sensing elements can be arranged in a waterproof enclosure.

In one configuration, the signal processing unit is configured to calculate the distance travelled by the signal from the location in the sensing element where the sensing element was exposed to a physical impact to the signal processing unit, and based on the distance travelled, calculate the location in the sensing element where the sensing element was exposed to the physical impact.

The sensing element can be arranged in the underground above or lateral to a power cable with a distance to the power cable. When the sensing element is arranged above the power cable, the distance to the power cable may be a vertical distance. This enables early warning if an excavator or the like is digging or in other ways disturbing the ground in an area where a power cable is buried. The signal processing unit can for this purpose be configured to issue a warning message when a variation is detected.

When, as described above, the sensing element is comprised in a monitoring device for depositing in the underground, the system may comprise multiple monitoring devices connected in series to form an extended monitoring device with an extended sensing element as described above. The interconnections of the monitoring devices may be configured similarly to what is described above for the sensing elements.

For example, can each of the multiple monitoring devices comprise an input terminal and an output terminal configured to connect to an output terminal and input terminal of another monitoring device, respectively. The output/input terminals may then include the sensing elements. When multiple monitoring devices are connected in series, a monitoring device of any length can be provided by selecting the number of monitoring devices of a specific length that matches the wanted length and connecting them in series.

To achieve a specific length, there may sometimes be necessary to cut a monitoring device to a shorter length. An input or output terminal can be connected to the cut end of the monitoring device, or any other termination suitable for connecting the monitoring device to the system may be arranged at the cut end of the monitoring device.

The connections between multiple monitoring devices can be a waterproof connection, or the connection between multiple monitoring devices can be arranged in a waterproof enclosure.

In one configuration, the signal processing unit is configured to calculate the distance travelled by the signal from the monitoring device to the signal processing unit, and based on the distance travelled, calculate the location of the monitoring device.

The monitoring device can be arranged in the underground above or lateral to a power cable with a vertical or lateral distance to the power cable. This enables early warning if an excavator or the like is digging or in other ways disturbing the ground in an area where a power cable is buried. The signal processing unit can for this purpose be configured to issue a warning message when a variation is detected.

In one configuration there is provided a monitoring device for monitoring an underground area, comprising a signal input terminal, a signal output terminal and a sensing element connected to the signal input terminal and the signal output terminal and where the sensing element is configured to interact with a signal received at the signal input terminal and to create a variation in the signal when the monitoring device is exposed to a physical impact.

The monitoring device may be used for monitoring any underground area where cables can be buried, such as both offshore, ie. under the seabed and onshore.

### Short description of the drawings

In the following, the invention will be described in more detail and with reference to the figures.
Figure 1 illustrates a system for detecting disturbances in an underground area close to a cable.
Figure 2 illustrates elements of one embodiment of a system for detecting disturbances in an underground area close to a cable.
Figure 3 illustrates elements of another embodiment of a system for detecting disturbances in an underground area close to a cable network.
Figure 4 illustrates a monitoring device for monitoring an underground area.
Figure 5 illustrates two monitoring devices interconnected to form a longer monitoring device.
Figure 6 illustrates an enclosure for providing waterproof arrangement of a connection between two sensing elements in a system

### Detailed description of the invention

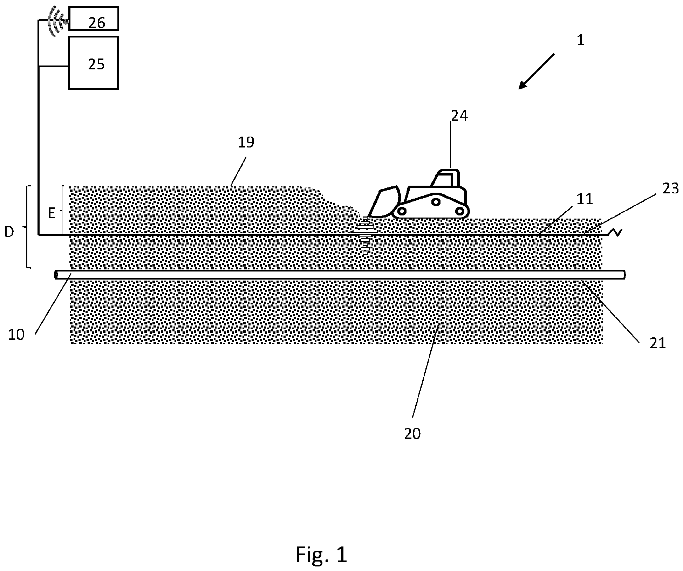

A system 1 for monitoring and detecting disturbances in an underground area close to a power cable in a power cable network is illustrated schematically in figure 1. In the figure, a power cable 10, which can be a part of a cable network or a single cable, is buried in the ground 20 at a cable level 21, which is at a depth D, *i.e.* a vertical distance D from the surface of the ground 19. The power cable can be placed in a protective duct, but most commonly the power cable is placed in an excavated trench, which is then filled in with soil.

To be able to discover any threats that may damage the power cable, the system 1 comprises a signal transmitter 26 which is connected to and configured to transmit signals to a sensing element 11. The sensing element 11 is arranged in the ground at a sensing level 23, which is at a depth E from the surface 19. The depth E is in the illustrated example less than the depth D, *i.e.* the sensing element 11 is buried shallower than the power cable 10, but in other embodiments, the depth E may be equal to the depth D. When, as illustrated in figure 1, an excavator 24 is digging into the ground 20, below the surface 19, it will reach the sensing element 11 before it reaches the cable 10. In this way, if it is detected that the excavator 24 has reached the sensing element, the digging can be stopped before it reaches the power cable 10 and creates real damage. In some embodiments the sensing element may be arranged in the ground lateral to, ie. at one or both sides of the power cable 10. The distance between the sensing element 11 and the power cable 10 should then be sufficiently small to ensure that any disturbances in the ground that represents a danger to the power cable 10 also will damage the sensing element.

For this purpose, the signal transmitter 26 transmits a signal to and through the sensing element 11. The sensing element 11 receives the signal from the signal transmitter 26 and is configured to interact with the signal from the signal transmitter 26 when the sensing element is exposed to a physical impact and to create a variation in the signal when such a physical impact is experienced. A variation in the signal may for example be an abrupt increase in the attenuation in the sensing element.

The system further comprises a signal processing unit 25 which is connected to the signal transmitter 26 and is also signally connected to the sensing element 11. The signal processing unit 25 may be connected to either or both ends of the sensing element 11. The signal processing unit 25 is configured to detect a variation in a signal from the sensing element whenever the sensing element has been exposed to a physical impact and to issue a warning message when the variation is detected.

The physical impact will typically be physical damage to the sensing element 11, total or partial, caused by an excavator 24 as illustrated in the figure, or disturbances caused by shift or relocation of the sensing element by the excavator 24, or other events. Such impacts cause a variation in the signal passing through the sensing element 11, which then can be detected by the signal processing unit 25. The physical impact can also include that the sensing element is broken, for example because the excavator 24 digs to a depth deeper than the sensing level 23. The variation in the signal may in this case be termination of the signal, *i.e.* the signal is suddenly cut off.

The signal processing unit 25 can also be configured to identify and record the point in time when a variation in the signal occurs. This time record can be used for a number of purposes, for example to document for a later time when an event which caused a physical impact happened and thereby what or who caused the physical impact. The time record can also be used by the signal processing unit 25 to calculate the distance travelled by the signal from a location of a physical impact in the sensing element 11 to the signal processing unit 25 and to localize the position where an event causing a physical impact occurred.

The paths of power cables and cable networks buried in the ground are generally drawn into maps of the relevant geographical area. Such maps may be public to enable workers and builders to know where to dig and where to be careful during construction works, road maintenance etc. The system 1 may comprise a catalogue over such maps, for example stored in a memory of the signal processing unit 25 or being otherwise accessible by the signal processing unit 25.

The time record can be used to find the length travelled by the signal, can then correlate the travelled length to a map, to thereby find the position of the physical impact.

The system may also comprise multiple sensing elements, for example located with a lateral distance between them or angled with respect to each other to cover a larger area or to cover multiple power cables/power cable networks. The signal processing unit 25 can then be configured to, when a variation in the signal is detected in one of the sensing elements, identify the location of the sensing elements, when a variation in the signal is detected in one of the sensing elements.

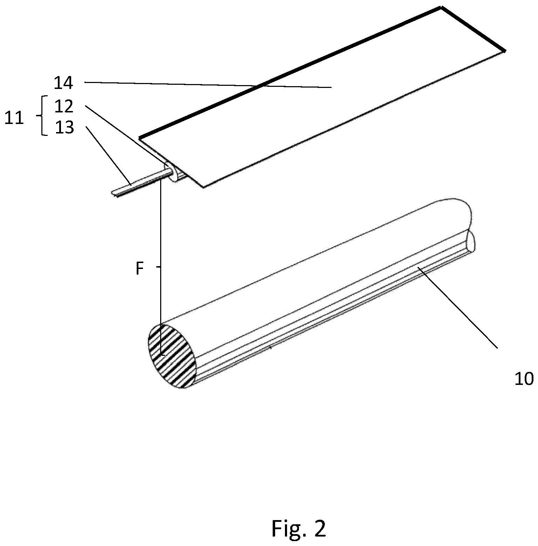

Illustrated in figure 2 is an embodiment where the sensing element 11 comprises an optical fiber 13. The signal transmitter 26 can then be a device configured to transmit an optical signal, for example a laser or other light source. To detect the variation in the optical signal the signal processing unit 25 can comprise or be connected to a reflectometer, for example an optical time domain reflectometer (OTDR) or other optical reflectometers, configured to detect a variation in the signal.

For example, when using an optical signal in an optical element/optical fiber, the signal processing unit can use an optical time domain reflectometer (OTDR) to determine where along the length of the optical element the variation has occurred and thus in which location the sensing element has been exposed to a physical impact. An OTDR transmits a series of optical pulses into the optical element, for example an optical fiber, and extracts, from the same end of the fiber, light that is scattered (Rayleigh backscatter) or reflected back from points along the fiber. The scattered or reflected light that is gathered back is used to characterize the optical fiber. The strength of the return pulses can be measured and integrated as a function of time and plotted as a function of length of the fiber.

The signal processing unit 25 can analyze the return pulses and determine where the sensing element has been exposed to a physical impact. This location can then be correlated with a map, thereby pinpointing the physical location of the physical impact.

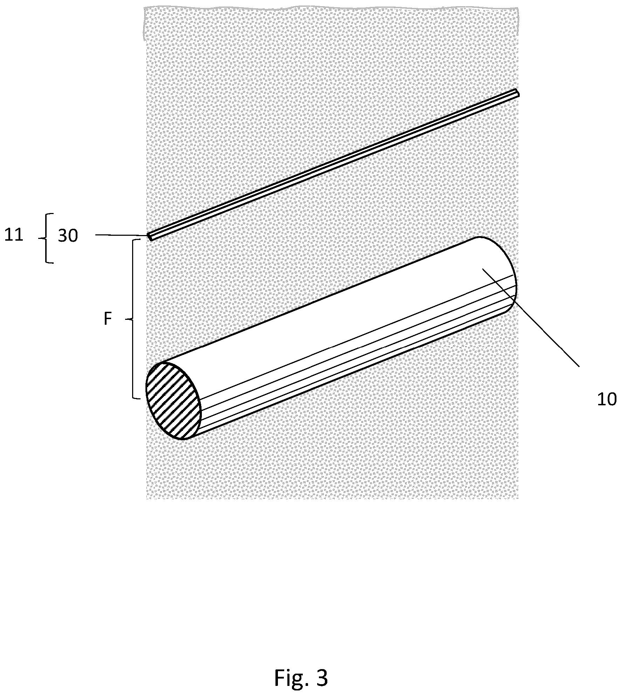

The sensing element may alternatively be or may additionally comprise an electrical conductor, for example embodied as a pair of electrical conductors, and the signal transmitter 26 will then be configured to transmit an electrical signal. Figure 3 illustrates a sensing element 11 in form of a pair 30 of electrical conductors arranged in the ground a distance F above a power cable 10. For detecting a variation in the electrical signal, the signal processing unit 25 can comprise an ohm meter, for example a high-resistivity ohm meter, or other suitable means for detecting and/or monitoring electrical signals.

Other examples of methods for detecting a variation in the electrical signal are to measure the resistance of a wire earthed at the far end, or two wires short-circuited at the far end. If the wire is cut, the intrusion may be identified by the interruption of the loop circuit. If the wire is earthed at the far end, since the electrical resistance at the break point is similar to the one at the far end, the overall variation is proportional to the ratio of length of the full link vs. the length at break.

Alternatively, or additionally, when using an electrical signal in electrical conductors 30, the signal processing unit 25 can comprise/use a time-domain reflectometer (TDR) or time-domain transmissometer (TDT) to determine where along the length of the sensing element 11 the variation has occurred and thus where the sensing element 11 has been exposed to a physical impact. A TDR is an electronic instrument used to determine the characteristics of electrical lines by observing reflected pulses, while a TDT is similar but measures transmitted pulses. When using TDT, the signal processing unit 25 may be connected to the opposite end of the sensing element 11 than the end where the signal is entering the sensing element.

A TDR measures reflections along a conductor. In order to measure those reflections, the TDR will transmit an incident signal onto the conductor and listen for its reflections. If the conductor is of a uniform impedance and is properly terminated, then there will be no reflections and the remaining incident signal will be absorbed at the far-end by the termination. Instead, if there are impedance variations/discontinuity, then some of the incident signal will be reflected back to the source. A TDR is similar in principle to radar.

The impedance of the discontinuity can be determined from the amplitude of the reflected signal. The distance to the reflecting impedance can also be determined from the time that a pulse takes to return. The limitation of this method is the minimum system rise time. The total rise time consists of the combined rise time of the driving pulse and that of the oscilloscope or sampler that monitors the reflections.

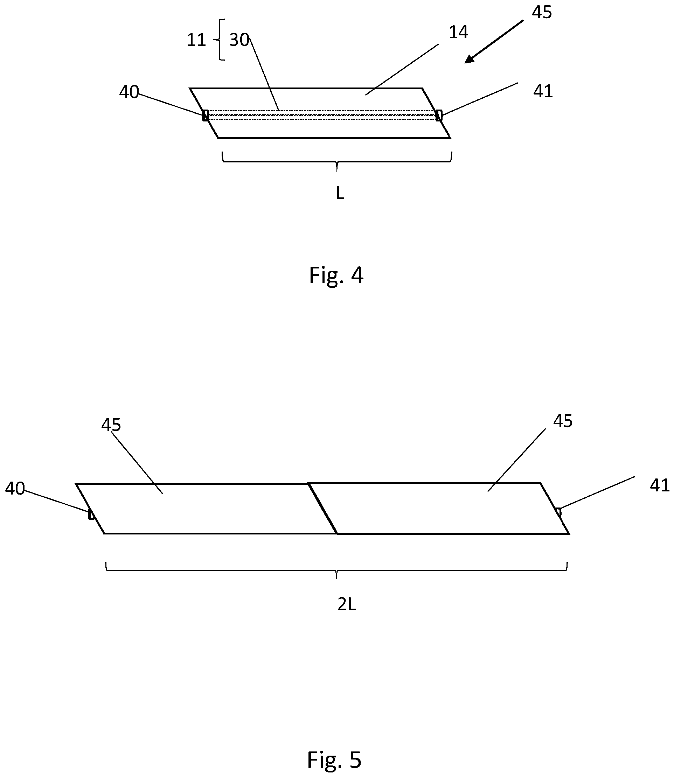

The sensing element 11 can be a stand-alone element, or it may be included in other devices. One example is to comprise the sensing element in a monitoring device 45 for depositing in the underground, as illustrated in figure 4 and described below. For example may the monitoring device 45 comprise a warning tape that 14 is commonly used for such purposes. The warning tape 14 is usually in the form of a plastic ribbon or the like, which is buried approximately sixty cm above the power cable or other type of cable that is to be protected. The warning tape usually carries indica identifying the cable owner and/or other information relevant for those who uncover it.

The sensing element 11 may be integrated in the other devices, such as the warning tape 14 or may be included in other ways. The monitoring device 45, for example the warning tape, may comprise a micro-duct 12 configured to receive the sensing element 11. The micro-duct 12 can be integrated in the monitoring device 45 during production and the sensing element may 11 be inserted into the micro-duct 12 during production, or may be inserted later, for example by blowing an optical element/optical fiber into the micro-duct 12. There may thus be a possibility of removing the sensing element 11 and replacing it with a new one if the sensing element is damaged.

The example in figure 2 illustrates a sensing element 11 comprising a micro-duct 12 and an optical element 13 which is inserted in the micro-duct 12. The micro-duct 12 and thereby the optical element 13 is included in/connected to a warning tape 14. The warning tape 14 with sensing element 11 is arranged buried in the ground a distance F above a power cable 10.

When an excavator 24 in figure 1 would happen to dig too deep in a place where the sensing element 11 in figure 2 is utilized, the warning tape 14 will become visible at the same time as the sensing element 11 is disturbed or breaks. The signal processing unit 25 will then detect a variation in the optical signal from the sensing element 11, may record the time of the variation and can calculate the distance along the sensing element 11 to where the variation originated. Based on the calculated distance, the position of the digging can be determined in a map or in geographical coordinates. The signal processing unit 25 can then issue an alarm or warning, including information on when and where the detected variation originated. This will in turn enable an operator to contact the excavator operator and stop the digging before it proceeds to damage the cable 10 buried below the warning tape 14 and sensing element 11. Although the warning tape becomes visible at the same time as the variation in optical signal is detected, the excavator operator may not see it in time to stop, whereas the system 1 may instantly trigger a signal to stop the excavator operator.

The monitoring device 45 can be designed as ready-to-use kits for on-site installation. For example, the monitoring device 45 may be provided in pre-fabricated lengths, comprising a signal input terminal in one end and a signal output terminal in the opposite end, where the sensing element is connected to the signal input terminal and the signal output terminal.

Figure 4 illustrates a monitoring device 45 comprising a warning tape 14 and a sensing element 11 in form of a pair 30 of electrical conductors connected to the warning tape 14. The warning tape 14 and the sensing element 11 has a length L. At one end, the sensing element 11 is connected to an input terminal 40, and on the other, opposite end, the sensing element 11 is connected to an output terminal 41.

Multiple monitoring devices can be connected together by connecting output 41 terminals to input terminals 40 to create a monitoring device of any length. Figure 5 illustrates two monitoring devices 45 of length L connected together to form a monitoring device of length 2L. By connecting a desired number of monitoring devices together as illustrated, a monitoring device of any length can be achieved.

The monitoring device can also be cut into a desired length, for example to adapt the total length of the monitoring device to a specific length. For example, may a pre-fabricated length of a monitoring device be 1 km, while the remaining distance needed is only 300 m. The monitoring device can then be cut to the correct length and an input or output terminal can be connected to the cut end of the monitoring device. The shortened monitoring device can then be connected to the previously arranged and interconnected monitoring devices to provide a correct total length of the monitoring device.

It should be noted that the monitoring device 45 can be the sensing element 11 itself with an input terminal 40 and an output terminal 41, or the monitoring device may be a micro-duct 12 with sensing element 11, where an input terminal 40 and output terminal 41 are connected to the ends. For some purposes, it may be advantageous to ensure that the interconnection between two or more monitoring devices 45 connected together is waterproof. For this purpose, waterproof terminals can be used as the output and input terminals for connecting monitoring devices together. Alternatively, or additionally, waterproof connectors may be used to connect the output and input terminals, or the connection may be arranged in a waterproof enclosure.

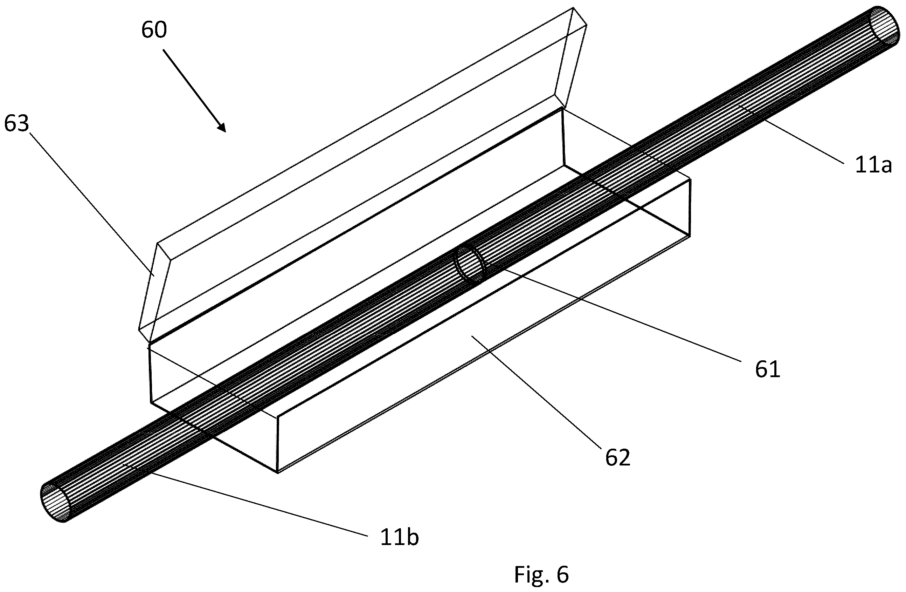

Figure 6 illustrates an enclosure 60 which provides waterproof arrangement of a connection 61 between two sensing elements 11a, 11b. The enclosure 60 comprises a housing 62 and a lid 63. The housing 62 is pre-filled or filled after arranging the connection 61 in the housing with a water repellant material, such as a water repellant gel. If the housing is filled after arranging the connection 61 in the housing, the housing may comprise a port for injection of the water repellant material after closing the housing 62 by the lid 63. The lid should be securely closing the housing after installation, by means of locking means such as strips, screws, etc. to ensure that the connection is at all times surrounded by the water repellant material.

## Claims

1. A system (1) for detecting disturbances caused by physical impacts in an underground area comprising a power cable (10), wherein the system comprises:
- a signal transmitter (26),
- a sensing element (11) configured to be buried in the ground (20) in the underground area and being signally connected to the signal transmitter (26) and configured to interact with a signal from the signal transmitter (26) to create a variation in the signal when the sensing element (11) is exposed to a physical impact, and
- a signal processing unit (25) connected to the signal transmitter (26) and signally connected to the sensing element (11), where the signal processing unit (25) is configured to detect the variation in a signal from the sensing element (11) and to identify and record the point in time when a variation in the signal occurs.

2. The system (1) according to claim 1, wherein the sensing element (11) is an optical fiber, and wherein the signal transmitter (26) is configured to transmit an optical signal.

3. The system (1) according to claim 2, wherein the signal processing unit (25) comprises an optical time domain reflectometer configured to detect a variation in the optical signal.

4. The system (1) according to claim 1, wherein the sensing element (11) is a pair of electrical conductors (30) and wherein the signal transmitter (26) is configured to transmit an electrical signal.

5. The system (1) according to claim 4, wherein the signal processing unit (25) comprises an ohm meter, for example a high-resistivity ohm meter.

6. The system (1) according to any one of the previous claims, where the sensing element (11) is comprised in a monitoring device (45) for depositing in the underground.

7. The system (1) according to claim 6, where the monitoring device comprises a micro-duct (12) configured to receive the sensing element (11).

8. The system (1) according to claim 1, comprising multiple sensing elements (11), and wherein the signal processing unit (25) is configured to identify the location of the sensing elements, when a variation in the signal is detected in one of the sensing elements (11).

9. The system (1) according to claim 8, wherein the multiple sensing elements (11) are connected in series to form an extended sensing element.

10. The system (1) according to claim 9, where each of the multiple sensing elements (11) comprises an input terminal and an output terminal configured to connect to an output terminal and input terminal of another sensing element, respectively.

11. The system (1) according to one of claims 9 or 10, where each connection between multiple sensing elements (11) is a waterproof connection.

12. The system (1) according to one of claims 9 or 10, where each connection between multiple sensing elements (11) is arranged in a waterproof enclosure.

13. The system (1) according to any one of the previous claims, where the signal processing unit (25) is configured to calculate the distance travelled by the signal from the location in the sensing element (11) where the sensing element (11) was exposed to a physical impact to the signal processing unit (25), and based on the distance travelled, calculate the location in the sensing element (11) where the sensing element (11) was exposed to the physical impact.

14. The system (1) according to any one of the previous claims, where the sensing element (11) is arranged in the underground above a power cable (10) with a vertical distance to the power cable (10).

15. The system (1) according to any one of the previous claims, wherein the signal processing unit (25) is configured to issue a warning message when a variation is detected.

16. A monitoring device for monitoring an underground area, comprising a signal input terminal (40), a signal output terminal (41) and a sensing element (11) connected to the signal input terminal (40) and the signal output terminal (41) and where the sensing element (11) is configured to interact with a signal received at the signal input terminal (40) and to create a variation in the signal when the monitoring device is exposed to a physical impact.
